Europäisches Patentamt

European Patent Office

Office européen des brevets

(11) Veröffentlichungsnummer: **0 410 334 A1**

(12) **EUROPÄISCHE PATENTANMELDUNG**

(21) Anmeldenummer: 90114019.4

(22) Anmeldetag: 21.07.90

(51) Int. Cl.5: **C11D 7/50, C23G 5/028**

(30) Priorität: 27.07.89 DE 3924888

(43) Veröffentlichungstag der Anmeldung:
30.01.91 Patentblatt 91/05

(84) Benannte Vertragsstaaten:
AT BE CH DE DK ES FR GB IT LI NL SE

(71) Anmelder: Kali-Chemie Aktiengesellschaft
Postfach 220, Hans-Böckler-Allee 20
D-3000 Hannover 1(DE)

(72) Erfinder: Buchwald, Hans
Am Rodelberg 51 A
D-3003 Ronnenberg 3(DE)
Erfinder: Raschkowski, Boleslaus
In der Hespe 246
D-3061 Wiedensahl(DE)
Erfinder: Brackmann, Andreas
Hedwigstrasse 10
D-3000 Hannover 1(DE)

(74) Vertreter: Lauer, Dieter, Dr.
c/o Kali-Chemie Aktiengesellschaft Postfach 220
D-3000 Hannover 1(DE)

(54) Azeotropartige und azeotrope Zusammensetzungen aus Trichlortrifluorethan, trans-1,2-Dichlorethylen und einem Alkanol.

(57) Beschrieben werden azeotropartige bzw. azeotrope Zusammensetzungen aus Trichlortrifluorethan mit trans-1,2-Dichlorethylen und einem der Alkanole Isopropanol oder Ethanol, die sich zur Verwendung in Reinigungsverfahren eignen.

EP 0 410 334 A1

## AZEOTROPARTIGE UND AZEOTROPE ZUSAMMENSETZUNGEN AUS TRICHLORTRIFLUORETHAN, TRANS-1,2-DICHLORETHYLEN UND EINEM ALKANOL

Die vorliegende Erfindung bezieht sich auf verbesserte azeotropartige und azeotrope Reinigungszusammensetzungen auf der Basis von 1,1,2-Trichlor-1,2,2-trifluorethan, trans-1,2-Dichlorethylen und einem Alkanol, sowie auf die Verwendung dieser Zusammensetzungen und ein Verfahren zur Reinigung von Oberflächen von Gegenständen mit diesen Zusammensetzungen.

Es ist allgemein bekannt, für industrielle Reinigungsverfahren oder für die Dampfentfettung neben reinen chlorierten und/oder fluorierten Kohlenwasserstoffen auch Gemische von Fluorchlorkohlenwasserstoffen (als Hauptlösungsmittel) mit einem Colösungsmittel einzusetzen. Solche Gemische können sowohl nichtazeotrop als auch azeotrop bzw. azeotropartig sein. Unter azeotropartig wird dabei verstanden, daß Gemische über einen größeren Konzentrationsbereich im wesentlichen konstant sieden (Änderung der Siedetemperatur um nicht mehr als 5 °C) und sich für den praktischen Einsatz daher ähnlich wie Azeotrope verhalten.

An die Lösungsmittel, die für Reinigungszwecke, insbesondere diejenigen, die für die Reinigung von gedruckten Leiterplatten eingesetzt werden sollen, werden sehr strenge Anforderungen gestellt. Solche Lösungsmittel sollten einen relativ niedrigen Siedepunkt aufweisen, nicht entflammbar und weitgehend untoxisch sein, sowie hohes Lösevermögen für die zu entfernenden Verschmutzungen, z.B. für Lötflußmittel oder Lötflußmittelrückstände, aufweisen. Diese Anforderungen lassen sich aber nicht mit nur einem einzigen, reinen Lösungsmittel erfüllen. Daher kommen in der Praxis eine Vielzahl von Lösungsmittelgemischen mit mehr oder weniger unterschiedlichen Zusammensetzungen zur Anwendung. Als Lösungsmittelgemische weisen insbesondere die azeotropen und azeotropartigen Zusammensetzungen anwendungstechnische Vorteile auf, da sie einerseits, wie bereits erwähnt, konstant bzw. im wesentlichen konstant sieden und andererseits dabei auch deren Zusammensetzung konstant bzw. im wesentlichen konstant bleibt. Bei Verwendung azeotrop bzw. azeotropartig siedender Zusammensetzungen kommt es somit nicht zur Fraktionierung der Lösungsmittelbestandteile der Zusammensetzungen, wodurch unerwünschte Eigenschaftsveränderungen der Zusammensetzungen, wie z.B. niedrigere Lösekraft, verminderte Inertheit gegenüber den zu reinigenden Gegenständen oder erhöhte Entflammbarkeit bei Verwendung entzündlicher Colösungsmittel, vermieden werden. Darüber hinaus lassen sich azeotrope bzw. azeotropartige Zusammensetzungen nach Gebrauch leicht durch gewöhnliche Destillation reinigen und stehen somit in einfacher Weise für die Wiederverwertung zur Verfügung, ohne daß die Charakteristika der ursprünglichen Zusammensetzung verlorengehen.

Es wurden daher bereits viele Anstrengungen unternommen, um azeotrope oder azeotropartige Reinigungszusammensetzungen mit den gewünschten Eigenschaften zu erzielen. Bedauerlicherweise ist es jedoch nicht möglich, die Bildung von azeotropen oder azeotropartigen Zusammensetzungen vorauszusagen. Dieses erschwert die Suche nach neuen azeotropen oder azeotropartigen Systemen, welche für Reinigungszwecke, insbesondere zur Entfernung von Lötflußmitteln oder Lötflußmittelrückständen eingesetzt werden können.

Trotz vieler Erfolge beim Auffinden azeotroper oder azeotropartiger Zusammensetzungen sind aber auch die bereits bekannten Gemische in ihren anwendungstechnischen Eigenschaften immer noch verbesserungsbedürftig. Insbesondere haben sich im Zusammenhang mit den technischen Weiterentwicklungen im Bereich der Flußmittel neue Anforderungen hinsichtlich der Entfernung dieser neuentwickelten Flußmittel ergeben. Diese Anforderungen werden durch die bekannten Lösungsmittelgemische nicht immer oder häufig nur unbefriedigend erfüllt. Oder andere bekannte Lösungsmittelgemische enthalten größere Anteile an toxikologisch und unter Sicherheitsaspekten (niedriger Siedepunkt, Flammpunkt) bedenklichen Lösungsmitteln (wie z.B. Methanol). Es besteht daher auch heute noch ein reger Bedarf an neuen azeotropen oder azeotropartigen Lösungsmittelgemischen mit neuen, speziellen Eigenschaften und erhöhter toxikologischer Unbedenklichkeit.

Es bestand daher die Aufgabe, neue azeotrope oder azeotropartige Lösungsmittelgemische zur Verfügung zu stellen, die die Nachteile des Standes der Technik überwinden und insbesondere zur Entfernung moderner Flußmittel besonders gut geeignet sind.

Zur Lösung dieser Aufgabe schlägt die Erfindung neue azeotropartige Zusammensetzungen mit einem Gehalt von 67,5 bis 77,0 Gew.-% an 1,1,2-Trichlor-1,2,2-trifluorethan (=R113), von 22,0 bis 28,0 Gew.-% an trans-1,2-Dichlorethylen und von 1,0 bis 4,5 Gew.-% eines Alkanols vor, wobei die Summe der Bestandteile 100 Gew.-% ist und wobei das Alkanol aus der Gruppe Isopropanol und Ethanol ausgewählt ist.

In einer Untervariante umfaßt die Erfindung Zusammensetzungen, die im Bereich von etwa 42 bis etwa 45 °C sieden (Atmosphärendruck). Diese azeotropartigen Zusammensetzungen zeichnen sich durch einen Gehalt von 69,0 bis 77,0 Gew.-% an 1,1,2-Trichlor-1,2,2-trifluorethan, von 22,0 bis 28,0 Gew.-% an trans-1,2-Dichlorethylen und von 1,0 bis 3,0 Gew.-% Isopropanol aus, wobei die Summe der Bestandteile 100 Gew.-% ist.

In einer sehr vorteilhaften Variante dieser erfindungsgemäßen Zusammensetzungen mit Isopropanol zeichnen sich diese durch ein azeotropes Verhalten und einen Gehalt von etwa 73,1 Gew.-% 1,1,2-Trichlor-1,2,2-trifluorethan, von etwa 24,7 Gew.-% trans-1,2-Dichlorethylen und etwa 2,2 Gew.-% Isopropanol aus. Diese azeotrope Zusammensetzung siedet bei etwa 42,6 °C (Atmosphärendruck) und zeigt besonders günstiges Verhalten hinsichtlich Lösekraft, Stabilität gegen Fraktionierung und Inertheit gegenüber den zu reinigenden Gegenständen.

In einer anderen Untervariante umfaßt die Erfindung Zusammensetzungen, die im Bereich von etwa 40 bis 44 °C sieden (Atmosphärendruck). Diese azeotropartigen Zusammensetzungen zeichnen sich durch einen Gehalt von 67,5 bis 75,5 Gew.-% an 1,1,2-Trichlor-1,2,2-trifluorethan (=R113), von 22,0 bis 28,0 Gew.-% an trans-1,2-Dichlorethylen und von 2,5 bis 4,5 Gew.-% Ethanol aus, wobei die Summe der Bestandteile 100 Gew.-% ist.

In einer sehr vorteilhaften Variante dieser erfindungsgemäßen Zusammensetzungen mit Ethanol zeichnen sich diese durch ein azeotropes Verhalten und einen Gehalt von etwa 71,7 Gew.-% 1,1,2-Trichlor-1,2,2-trifluorethan (=R113), von etwa 24,9 Gew.-% trans-1,2-Dichlorethylen und von etwa 3,4 Gew.-% Ethanol aus. Diese azeotrope Zusammensetzung siedet bei etwa 40,4 °C (Atmosphärendruck) und zeigt ebenfalls besonders günstiges Verhalten hinsichtlich Lösekraft, Stabilität gegen Fraktionierung und Inertheit gegenüber den zu reinigenden Gegenständen.

Die erfindungsgemäßen Zusammensetzungen sind bei Raumtemperatur klare Lösungen, denen an sich bekannte Additive zugesetzt werden können (hierdurch wird das relative Verhältnis der Bestandteile Trichlortrifluorethan, Dichlorethylen und Alkanol zueinander, welches durch die obigen Gew.-%-Angaben festgelegt ist, nicht verändert).

Eine Gruppe an sich bekannter Additive sind Stabilisatoren. Unter dieser Gruppe werden solche Verbindungen zusammengefaßt, die eine unerwünschte Reaktion von Bestandteilen der Zusammensetzung untereinander oder mit anderen Reaktionspartnern, wie beispielsweise Luftsauerstoff, Wasser, Metall usw., verhindern. Bekannte Stabilisatoren sind beispielsweise Nitroalkane, insbesondere Nitromethan, Nitroethan, Alkylenoxide, insbesondere Butylenoxid, oder verzweigte Alkinole wie z.B. 2-Methyl-butin-(3)-ol-(2). Diese Stabilisatoren können allein oder miteinander in Kombination eingesetzt sein, wobei Mengen von 0,01 bis 5 Gew.-%, vorzugsweise 0,05 bis 1 Gew.-%, bezogen auf das Gesamtgemisch gut geeignet sind.

Eine weitere Gruppe von Additiven umfaßt an sich bekannte Verbindungen aus der Gruppe der Korrosionsinhibitoren, nichtionische oder ionische Emulgatoren, Farbstoffe etc.

Die oben genannten Zusammensetzungen haben zahlreiche Anwendungsmöglichkeiten auf dem Sektor der Reinigung und/oder Dampfentfettung. Bei diesen an sich bekannten Verfahren wird der zu reinigende Gegenstand in ein oder mehreren Stufen in flüssiges und/oder dampfförmiges Reinigungsgemisch getaucht oder mit flüssigem Reinigungsgemisch besprüht. Die Reinigungswirkung kann in bekannten Verfahren durch Anwendung von erhöhter Temperatur und/oder Ultraschall und/oder Rühren gesteigert werden. Ebenso ist eine Verbesserung der Reinigungswirkung durch mechanische Einwirkung, wie z.B. Bürsten, bekannt.

Beispielsweise verwendet die elektronische Industrie für Lötverfahren vorherrschend organische Harzflußmittel, deren Überschüsse nach dem Lötvorgang von Leiterplatten entfernt werden müssen. Dies erfolgt mit organischen Lösungsmitteln, die mit den Leiterplatten und den elektronischen Teilen verträglich sind, d.h. das Lösungsmittel darf nicht mit diesen reagieren. Die zu entfernenden Harzflußmittel sind Gemische polarer und nichtpolarer Verbindungen und enthalten oftmals zusätzlich spezielle Aktivatoren. Fluorierte Kohlenwasserstoffe allein, die nichtpolar sind, sind zur Entfernung der polaren Komponenten der Harze nicht wirksam. Ebensowenig sind viele der an sich bekannten binär oder ternär zusammengesetzten Lösungsmittelgemische in der Lage, insbesondere spezielle hochaktivatorhaltige Flußmittel vollständig zu entfernen. Die Gründe hierfür liegen z.B. im nicht immer ausreichenden Lösevermögen dieser Gemische oder darin, daß sie z.B. wegen ihres nicht oder wenig azeotropen Verhaltens beim Sieden zur Fraktionierung neigen, wodurch deren Verwendbarkeit eingeschränkt wird. Die erfindungsgemäßen Zusammensetzungen können jedoch sowohl die polaren als auch die nichtpolaren Komponenten entfernen und sind daher als Entfernungsmittel für Harzflußmittel, insbesondere auch für solche mit hohem Aktivatorgehalt, auf breiter Basis wirksam. Besonders gut geeignet für diese Anwendung ist die azeotrope Zusammensetzung aus R113/trans-1,2-Dichlorethylen/Isopropanol mit der Zusammensetzung von 73,1 %/24,7 %/2,2 % oder die azeotrope Zusammensetzung aus R113/trans-1,2-Dichlorethylen/Ethanol mit der Zusammensetzung von 71,7 %/24,9 %/3,4 %. Aber auch die anderen erfindungsgemäßen Zusammensetzungen von R113 mit trans-1,2-Dichlorethylen und Isopropanol oder Ethanol zeigen sehr gute Ergebnisse.

3

So lassen sich unbestückte und bestückte (insbesondere auch SMD-bestückte) Leiterplatten auch bei Verwendung von Flußmitteln mit hohem Aktivatoranteil problemlos mit den erfindungsgemäßen Zusammensetzungen reinigen, ohne daß es zu den bei Einsatz der üblichen Reinigungsmittel gefürchteten "weißen Belägen" kommt.

Die neuen Zusammensetzungen gemäß der Erfindung sind auch erwünschte Systeme für Kühl- und Schmiermittel, da die Zusammensetzungen eine niedrige Oberflächenspannung, eine niedrige Viskosität und zum größten Teil eine geeignet hohe Dichte besitzen. Die obigen physikalischen Eigenschaften sind jene, die für Schmiermittelanwendungen erwünscht sind. Beispielsweise sind die Zusammensetzungen nach der Erfindung erwünscht, wenn das Gemisch als ein Schmiermittel in metallverarbeitenden Maschinen verwendet wird, wie z.B. beim Bohren, Fräsen, Drehen, Gewindeschneiden, Stanzen oder dergleichen, wo eine rückstandsfreie Oberfläche erforderlich ist. Für diese Anwendungen können insbesondere auch an sich bekannte Schmiermitteladditive (wie z.B. in DE-OS 33 42 852 oder DE-OS 33 35 870 be schrieben) zugesetzt werden.

Die niedrige Oberflächenspannung, die hohe Benetzungsfähigkeit und Dichte der Zusammensetzungen gemäß der Erfindung machen diese besonders geeignet zur Reinigung von Kapillarsystemen.

Die erfindungsgemäßen Zusammensetzungen können beispielsweise auch wie folgt eingesetzt werden:
- zur Reinigung von Kleinteilen bzw. Schüttgut (vorzugsweise in geschlossenen Anlagen),
- zum Strippen von Lack,
- als spezielles Lösungs-, Extraktions- und/oder Umkristallisationsmittel in der chemischen und pharmazeutischen Industrie.

Es sind zwar bereits eine Vielzahl azeotropartiger Reinigungszusammensetzungen im Stand der Technik bekannt, die als Basislösungsmittel den Fluorchlorkohlenwasserstoff 1,1,2-Trichlor-1,2,2-trifluorethan (=R113) enthalten und die zur Entfernung von Harzlötflußmitteln eingesetzt werden. Die Anwendung dieser bekannten Zusammensetzungen gewährleistet jedoch nicht in jedem Fall den sehr hohen Reinheitsgrad, der in speziellen Einsatzgebieten, z.B. bei der Reinigung von Bauteilen und Leiterplatten in der elektronischen Industrie, erforderlich ist. Sie sind daher in ihren Eigenschaften oftmals noch unzureichend und verbesserungsbedürftig. Wie eingangs bereits erwähnt, ist es auch in Kenntnis der azeotropen bzw. azeotropartigen Zusammensetzungen des Standes der Technik jedoch nicht möglich, die Bildung azeotroper bzw. azeotropartiger Zusammensetzungen vorherzusagen. Erschwerend kommt hinzu, daß es nicht ausreicht, nur eine Zusammensetzung mit azeotropem oder azeotropartigem Verhalten aufzufinden. Diese Zusammensetzungen müssen vielmehr darüber hinaus noch weitere wesentliche anwendungstechnische Anforderungen wie z.B. insbesondere hohes Lösevermögen, Inertheit und weitgehende toxikologische Unbedenklichkeit erfüllen. Es überrascht daher umso mehr, daß die neuen erfindungsgemäßen Zusammensetzungen, die R113, trans-1,2-Dichlorethylen und Isopropanol bzw. Ethanol enthalten, überlegene Reinigungseigenschaften zeigen und für die genannten Anwendungen sehr gut geeignet sind, obwohl sie als polare Komponente nur niedrige Alkanolgehalte von bis zu maximal 4,5 Gew.-% enthalten. Reinigungszusammensetzungen des Standes der Technik enthalten demgegenüber oftmals höhere Alkanolanteile, um eine ausreichende Lösekraft sicherzustellen. Darüber hinaus gelingt es durch die erfindungsgemäßen Zusammensetzungen, den Anteil an vollhalogeniertem Fluorchlorkohlenwasserstoff gegenüber solchen üblichen Lösungsmittelgemischen des Standes der Technik, die oftmals als Hauptlösungsmittel nur vollhalogenierte Fluorchlorkohlenwasserstoffe enthalten, zu senken, und zwar ohne daß dabei die Reinigungswirkung der Zusammensetzungen beeinträchtigt wird.

Durch die erfindungsgemäßen Zusammensetzungen werden somit auf einem breiten Anwendungsgebiet neue Problemlösungen ermöglicht.

Die folgenden Beispiele sollen die Erfindung näher erläutern, ohne sie jedoch in ihrem Umfang zu begrenzen. Sofern nicht anders angegeben, sind % immer Gewichtsprozent.


Beispiel 1: Reinigung von Leiterplatten

In einer handelsüblichen 3-Kammer-Reinigungsanlage wurden Reinigungsversuche mit Leiterplatten, die entweder mit einem üblichen halogenhaltigen Lötflußmittel (Versuche Nr. 1 und 3) oder die mit stark aktivatorhaltigem Lötflußmittel (Versuche Nr. 2 und 4) verunreinigt waren, vorgenommen. Die Reinigungszusammensetzungen, Reinigungsbedingungen und Reinigungsergebnisse sind in Tabelle 1 wiedergegeben. Gleichgute Ergebnisse ließen sich auch bei Verwendung der erfindungsgemäßen Zusammensetzungen in 2-Kammer-Reinigungsanlagen erzielen.

Tabelle 1:

| Nr. | Zusammensetzungen für Bad 1, 2 und 3 | Reinigungs- bedingungen | Ergebnis |
|---|---|---|---|
| 1 | R113/trans-1,2-Di-chlorethylen/Isopro-panol 77,0 %/ 22,0 %/ 1,0 % | 3-Bad: 1) 3 Min. Ultra-schall 2) 1 Min. Ultra-schall 3) 1 Min. Dampf-entfettung | ++ |
| 2 | R113/trans-1,2-Di-chlorethylen/Isopro-panol 73,1 %/ 24,7 %/2,2 % | 3-Bad: 1) 3 Min. Ultra-schall 2) 1 Min. Ultra-schall 3) 1 Min. Dampf-entfettung | ++ |

(Forts. Tab. 1:)

| Nr. | Zusammensetzungen für Bad 1, 2 und 3 | Reinigungsbedingungen | Ergebnis |
|---|---|---|---|
| 3 | R113/trans-1,2-Di-chlorethylen/Ethanol 75,5 %/ 22,0 %/ 2,5 % | 3-Bad: 1) 3 Min. Ultraschall 2) 1 Min. Ultraschall 3) 1 Min. Dampfentfettung | ++ |
| 4 | R113/trans-1,2-Di-chlorethylen/Ethanol 71,7 %/ 24,9 %/ 3,4 % | 3-Bad: 1) 3 Min. Ultraschall 2) 1 Min. Ultraschall 3) 1 Min. Dampfentfettung | ++ |

In den in der Spalte "Ergebnis" mit "+ +" gekennzeichneten Fällen ist eine sehr gute Reinigungswirkung erzielt worden und es kam nicht zur Bildung "weißer Beläge". Es ist deutlich sichtbar, daß die erfindungsgemäßen Zusammensetzungen hervorragende Reinigungsleistungen aufweisen.

Beispiel 2: Reinigung von Schüttgut

Schüttgut (Transistoren-Kappen) wurden zur Entfernung von Ziehölen in einer 2-Kammer-Anlage (3 Minuten Ultraschall, 1 Minute Dampfentfettung) mit einer azeotropen Zusammensetzung aus 71,7 % R113, 24,9 % trans-1,2-Dichlorethylen und 3,4 % Ethanol gereinigt. Nach Behandlung war das Schüttgut einwandfrei sauber.

Beispiel 3: Reinigung von Schüttgut

Schüttgut (Transistoren-Kappen) wurden zur Entfernung von Ziehölen in einer 2-Kammeranlage (3 Minuten Ultraschall, 1 Minute Dampfentfettung) mit einer azeotropen Zusammensetzung aus 73,1 % R113, 24,7 % trans-1,2-Dichlorethylen und 2,2 % Isopropanol gereinigt. Nach Behandlung war das Schüttgut einwandfrei sauber.

**Ansprüche**

1. Azeotropartige Zusammensetzungen, gekennzeichnet durch einen Gehalt von 67,5 bis 77,0 Gew.-% an 1,1,2-Trichlor-1,2,2-trifluorethan (=R113), von 22,0 bis 28,0 Gew.-% an trans-1,2-Dichlorethylen und von 1,0 bis 4,5 Gew.-% eines Alkanols, ausgewählt aus der Gruppe Isopropanol und Ethanol, wobei die Summe der Bestandteile 100 Gew.-% ist.

2. Zusammensetzungen nach Anspruch 1, gekennzeichnet durch einen Gehalt von 69,0 bis 77,0 Gew.-% an 1,1,2-Trichlor-1,2,2-trifluorethan (=R113), von 22,0 bis 28,0 Gew.-% an trans-1,2-Dichlorethylen und von 1,0 bis 3,0 Gew.-% Isopropanol, wobei die Summe der Bestandteile 100 Gew.-% ist.

3. Zusammensetzung nach Anspruch 2, gekennzeichnet durch eine azeotrope Zusammensetzung von etwa 73,1 Gew.-% an 1,1,2-Trichlor-1,2,2-trifluorethan (=R113), von etwa 24,7 Gew.-% trans-1,2-Dichlorethylen und etwa 2,2 Gew.-% an Isopropanol und mit einem Siedepunkt von etwa 42,6 °C bei Atmosphärendruck.

4. Zusammensetzungen nach Anspruch 1, gekennzeichnet durch einen Gehalt von 67,5 bis 75,5 Gew.-% an 1,1,2-Trichlor-1,2,2-trifluorethan (=R113), von 22,0 bis 28,0 Gew.-% trans-1,2-Dichlorethylen und von 2,5 bis 4,5 Gew.-% Ethanol, wobei die Summe der Bestandteile 100 Gew.-% ist.

5. Zusammensetzung nach Anspruch 4, gekennzeichnet durch eine azeotrope Zusammensetzung von etwa 71,7 Gew.-% an 1,1,2-Trichlor-1,2,2-trifluorethan (=R113), von etwa 24,9 Gew.-% trans-1,2-Dichlorethylen und etwa 3,4 Gew.-% Ethanol und mit einem Siedepunkt von etwa 40,4 °C bei Atmosphärendruck.

6. Zusammensetzungen nach einem der vorhergehenden Ansprüche, gekennzeichnet durch einen zusätzlichen Gehalt an Stabilisator von 0,01 bis 5 Gew.-%, vorzugsweise 0,05 bis 1 Gew.-%, bezogen auf das Gesamtgemisch, vorzugsweise aus der Gruppe Nitroalkan, Alkylenoxid und/oder Alkinol.

7. Verwendung der Zusammensetzungen nach einem der vorhergehenden Ansprüche in Tauch- und/oder Sprüh-Reinigungsverfahren oder bei der Dampfentfettung.

8. Verfahren zum Reinigen von Oberflächen von Gegenständen, dadurch gekennzeichnet, daß man die Oberfläche mit azeotropartigen Zusammensetzungen nach einem der Ansprüche 1 bis 6 behandelt.

9. Verfahren nach Anspruch 8, dadurch gekennzeichnet, daß die zu reinigenden Oberflächen mit Lötflußmittel oder Lötflußmittelrückständen verunreinigte gedruckte Leiterplatten sind.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| P,X | EP-A-0 376 439 (E.I. DU PONT DE NEMOURS) <br> * ganzes Dokument, besonders Seite 3, Zeilen 5-7,56-58; Seite 4, Zeilen 45-49 * | 1,4,6-9 | C 11 D 7/50 <br> C 23 G 5/028 |
| P,A | --- | 2,3,7 | |
| Y | EP-A-0 309 082 (E.I. DU PONT DE NEMOURS) <br> * ganzes Dokument * <br> --- | 1,6-9 | |
| Y | FR-A-2 100 289 (IMPERIAL CHEMICAL IND.) <br> * Ansprüche * <br> --- | 1,6-9 | |
| Y | US-A-3 903 009 (A.W. BAUER) <br> * Zusammenfassung * <br> --- | 1,6-9 | |
| A | GB-A-1 377 156 (I.S.C. CHEMICALS LIMITED) <br> * Ansprüche * <br> --- | 1,7-9 | |
| A | US-A-4 803 009 (R.A. GORSKI) <br> * Ansprüche * <br> ----- | 1,6-9 | RECHERCHIERTE SACHGEBIETE (Int. Cl.5) <br><br> C 11 D 7/00 <br> C 23 G 5/00 |

Der vorliegende Recherchenbericht wurde für alle Patentansprüche erstellt

| Recherchenort | Abschlußdatum der Recherche | Prüfer |
|---|---|---|
| BERLIN | 28-09-1990 | PELLI-WABLAT B |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus andern Gründen angeführtes Dokument
.....................................................................
& : Mitglied der gleichen Patentfamilie, übereinstimmendes
  Dokument

EPO FORM 1503 03.82 (P0403)